# FASCICULE DE BREVET EUROPEEN

(11) **EP 0 720 790 B1**
(45) Date de publication et mention de la délivrance du brevet: **14.01.1998**
(21) Numéro de dépôt: 94928430.1
(22) Date de dépôt: 23.09.1994
(51) Int. Cl.: H03K 17/96, D06F 75/08

(54) **DISPOSITIF DE DETECTION DE COURANT ELECTRIQUE PAR MICRO-FUITE**
SCHALTUNG ZUM ERKENNEN SCHWACHER ELEKTRISCHER STRÖME BEI BERÜHRUNG
DEVICE FOR DETECTING AN ELECTRIC CURRENT BY MICRO-LEAKAGE

(30) Priorité: 24.09.1993 FR 9311624
(43) Date de publication de la demande: 10.07.1996
(73) Titulaire: SEB S.A., 69130 Ecully (FR)
(72) Inventeur: CUBIZOLLES, Serge, F-69007 Lyon (FR); GIOVALLE, Christian, F-38780 Pont-Evêque (FR)
(86) Numéro de dépôt international: FR9401111
(87) Numéro de publication internationale: WO9508870

(56) Documents cités:
- EP-A- 0 012 044
- WO-A-92/19905
- DD-A- 228 945
- DE-A- 2 430 110
- DE-A- 9 005 890
- GB-A- 2 021 771
- GB-A- 2 154 322
- GB-A- 2 199 962

## Description

### DOMAINE TECHNIQUE

L'invention se rapporte au domaine de la détection de présence appliquée aux appareils électriques.

La présente invention concerne plus particulièrement un dispositif de détection de courant électrique par micro-fuite, par l'intermédiaire d'un contact entre l'utilisateur et un appareil électrique, pour contrôler et/ou asservir le fonctionnement dudit appareil.

Un tel dispositif est particulièrement bien adapté pour son utilisation sur des appareils électroménagers et notamment sur des fers à repasser, mais il est évident qu'un tel dispositif peut être utilisé sur tout appareil électrique domestique ou industriel, lequel doit présenter une facilité et une sécurité d'utilisation.

### TECHNIQUE ANTERIEURE

Il est déjà connu dans l'art antérieur d'utiliser un courant de fuite pour détecter une présence par contact. Le fonctionnement de tels dispositifs est souvent altéré soit par une isolation non constante entre un utilisateur desdits dispositifs et la terre, soit par une inversion du branchement électrique desdits dispositifs.

Il est ainsi connu par l'intermédiaire du document DE-U-9005890 de réaliser un dispositif de détection avec lequel une partie du corps d'un utilisateur réalise un pont électrique entre des moyens de liaison électrique. Ces derniers sont reliés à un circuit électronique de façon à optimiser la puissance dissipée dans un fer à souder, et ceci en fonction d'une préhension dudit fer par l'utilisateur. Le circuit électronique comprend un générateur d'impulsions lesquelles sont véhiculées par le pont électrique entre les moyens de liaison. Le document D1 décrit également une variante de réalisation d'un tel dispositif avec un seul moyen de liaison électrique permettant de transmettre au circuit électronique un signal issu du bruit électromagnétique ambiant lorsque l'utilisateur vient en contact avec le moyen de liaison électrique. Le dispositif ainsi décrit dans ce document présente l'inconvénient de ne pas tenir compte d'une part d'une éventuelle altération de l'isolation électrique de l'utilisateur par rapport à la terre et d'autre part d'utiliser les moyens d'amplification et de filtration du signal ne contribuant pas à la simplification du circuit électronique.

L'objet de la présente invention vise à fournir un appareil électrique, du type électroménager par exemple, comportant un système de détection de présence de la main de l'utilisateur dudit appareil électrique.

Un autre objet de la présente invention consiste à fournir un circuit électronique de détection particulièrement simple et fiable quel que soit le degré d'isolement électrique de l'utilisateur d'un appareil électrique comprenant un dispositif de détection, par rapport à la terre, et quel que soit le sens du branchement électrique dudit appareil.

Un objet supplémentaire de la présente invention vise à fournir aux utilisateurs d'appareils électriques, et électroménagers par exemple, un dispositif dont les moyens structurels et électroniques mis en oeuvre sont simples et peu coûteux.

Un objet additionnel de la présente invention vise à fournir des appareils électroménagers par exemple, lesquels présentent un meilleur confort d'utilisation, de même qu'une sécurité d'utilisation accrue.

### EXPOSE DE L'INVENTION

Les objets de l'invention sont atteints à l'aide d'un dispositif de détection associé à un appareil électrique et à un circuit électronique pour détecter un courant de fuite traversant au moins partiellement, une partie du corps d'un utilisateur de l'appareil électrique lorsque ladite partie du corps vient en contact avec des moyens de liaison électrique agencés sur un moyen de préhension de l'appareil, assurant ainsi la transmission du courant de fuite du circuit électronique vers le corps de l'utilisateur, et permettant de commander au moins une partie du fonctionnement de l'appareil électrique par respectivement un contact ou une séparation entre le moyen de préhension et l'utilisateur,
caractérisé en ce que chaque moyen de liaison électrique est relié à un étage de détection de courant de fuite, de façon à permettre une détection lorsque le courant de fuite circule entre les moyens de liaison électrique, et lorsque ledit courant circule entre l'un des moyens de liaison électrique et la terre.

### DESCRIPTION SOMMAIRE DES DESSINS

D'autres particularités et avantages de l'invention apparaîtront et ressortiront plus en détail à la lecture de la description faite ci-après, en référence aux dessins annexés, donnés à titre d'exemples illustratifs non limitatifs dans lesquels :
- la figure 1 représente une vue globale d'un fer à repasser comportant un dispositif de détection conforme à l'invention,
- la figure 2 représente un schéma électronique du circuit électronique de détection conforme à l'invention.
- la figure 3 représente une variante de réalisation du circuit électronique de détection conforme à l'invention.

### MEILLEURE MANIERE DE REALISER L'INVENTION

Dans la description détaillée qui va suivre, il est fait allusion plus particulièrement à un dispositif de détection de présence pour un fer à repasser, mais il est évident que l'invention ne se limite pas à cette conception particulière.

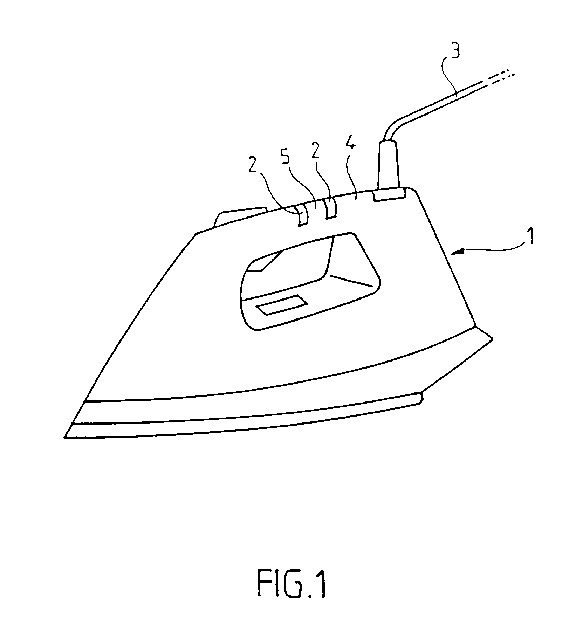

La figure 1 représente une vue générale, en perspective, d'un fer à repasser 1 comportant un dispositif de détection de présence conforme à l'invention. Le dispositif de détection est donc utilisé sur un appareil électrique du type électroménager.

Le fer à repasser 1 est constitué notamment d'une poignée 4, d'un conduit d'alimentation 3 et de moyens de liaison électrique 2. Ces derniers sont réalisés en un matériau conducteur électrique. Ainsi les moyens de liaison électrique 2 sont agencés sur un moyen de préhension d'un appareil électrique. Avantageusement, les moyens de liaison électrique sont de préférence constitués de deux barrettes métalliques agencées sur la poignée 4 du fer à repasser 1. Les barrettes sont de préférence réalisées en laiton nickelé. Les barrettes peuvent être associées par exemple à des touches tactiles.

Les moyens de liaison électrique 2 sont constitués de deux barrettes métalliques reliées au circuit électronique 10 par des points connexion (C1, C2) et isolées électriquement l'une de l'autre par un espacement, de façon à permettre à la partie du corps de l'utilisateur qui vient en contact avec lesdits moyens de liaison électrique 2 de remplir la fonction de pont électrique, soit entre les barrettes métalliques, soit entre l'une des barrettes métalliques et la terre. Les barrettes métalliques s'intègrent parfaitement dans l'ergonomie de la poignée 4.

Les moyens de liaison électrique 2 sont isolés électriquement l'un par rapport à l'autre par l'intermédiaire d'une portion 5 de la poignée 4 réalisée en un matériau isolant électrique. L'écartement des moyens de liaison électrique est avantageusement compris entre 1 et 30 millimètres et préférentiellement égal à 5 millimètres.

Selon une variante de réalisation du dispositif de détection conforme à l'invention, le circuit électronique 10 est agencé dans une unité externe et séparée de l'appareil électrique en liaison électrique avec ledit appareil électrique. La liaison électrique est réalisée de préférence par le conduit d'alimentation 3.

Les moyens de liaison électrique 2 sont disposés sur la poignée 4 ou agencés dans des logements prévus à cet effet et ménagés dans ladite poignée 4, de manière à présenter une surface conductrice accessible à la main d'un utilisateur du fer, lorsque ladite main vient en contact avec la poignée 4.

Le circuit électronique 10 de détection est directement branché sur l'alimentation électrique du secteur. Il en est de même pour les éléments chauffants (non représentés aux figures), contenus dans le fer à repasser. Le branchement sur l'alimentation électrique du secteur du circuit électronique 10 peut se faire notamment à l'aide du conduit d'alimentation 3. Ce dernier peut également servir, selon une variante de réalisation du fer à repasser comportant un dispositif de détection conforme à l'invention, à fournir de la vapeur au fer lors du repassage.

Le dispositif conforme à l'invention est monté par exemple sur un appareil électrique comportant des moyens de chauffe dont l'alimentation électrique est contrôlée par le circuit électrique 10, en fonction de l'apparition ou de la disparition du courant de fuite.

Le dispositif peut également être monté sur un appareil électrique comportant des moyens de production de vapeur, laquelle est asservie automatiquement par l'intermédiaire du courant de fuite.

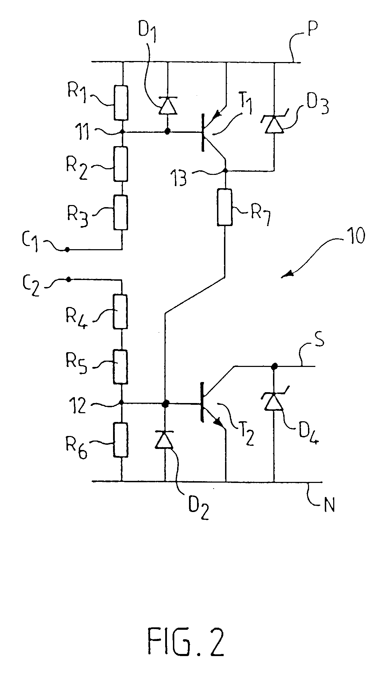

La figure 2 représente le schéma électronique du circuit électronique 10 conforme à l'invention. Les moyens de détection du circuit électronique 10 sont constitués notamment de deux étages de détection comprenant chacun un transistor bipolaire.

Le premier étage comporte donc un transistor bipolaire T1, des résistances R1, R2 et R3, une diode D1, ainsi qu'une diode Zéner D3.

L'émetteur du transistor T1 est branché directement sur une borne P d'alimentation du secteur. La base 11 du transistor T1 est reliée à la borne P à travers une résistance R1, laquelle est branchée en parallèle avec une diode D1 d'une part et la base 12 est reliée à une borne N d'alimentation à travers une résistance R6 branchée en parallèle avec une diode D2 d'autre part. La diode D1 est destinée à protéger la jonction base-émetteur du transistor T1. La résistance R1 permet d'appliquer une tension sur la base 11 du transistor T1 lorsque ladite résistance R1 est traversée par un courant électrique. La diode Zéner D3 est branchée entre le collecteur 13 du transistor T1 et la borne P de manière à maintenir la tension électrique entre la borne P et le collecteur 13 en deçà d'une valeur sensiblement égale à 100 Volts, pour protéger la jonction émetteur-collecteur que présente le transistor T1.

Le deuxième étage de détection comporte un transistor T2 dont l'émetteur est relié directement à une borne N d'alimentation du secteur. L'un des étages de détection est donc relié à la phase et l'autre est relié au neutre de l'alimentation électrique du secteur. Le collecteur S du transistor T2 est relié à une unité de contrôle et / ou de régulation.

La base 12 du transistor T2 est reliée à la borne N à travers une résistance R6, laquelle présente une diode D2 branchée en parallèle avec ladite résistance R6 de manière à protéger la jonction base-émetteur du transistor T2. La résistance R6 permet d'appliquer une tension sur la base 11 lorsque ladite résistance R6 est traversée par un courant. La jonction émetteur-collecteur est protégée par une diode Zéner D4. Cette dernière est donc branchée entre le collecteur S du transistor T2 et la borne N.

Le circuit électronique 10, représenté à la figure 2, présente des transistors bipolaires T1 et T2, dont les émetteurs sont connectés sur une alimentation électrique, le collecteur 13 du premier transistor T1 étant relié à la base 12 du deuxième transistor T2 à travers une résistance R7, et le collecteur S du deuxième transistor T2 étant relié à un moyen de commande et / ou de contrôle d'un appareil électrique.

Les deux étages de détection sont ainsi reliés électriquement par l'intermédiaire de la résistance R7.

Le circuit électronique 10 présente des points de connexion C1, C2, dont chacun est relié d'une part à un moyen de liaison électrique 2, et d'autre part à la base d'un transistor bipolaire T1, T2. Les points de connexion C1, C2 sont avantageusement prévus sous les moyens de liaison électrique 2.

Le point de connexion C1 est connecté à la base 11 du transistor T1, à travers une résistance R2 et une résistance R3 branchées en série.

Le point de connexion C2 est connecté à la base 12 du transistor T2, à travers une résistance R4 et une résistance R5 branchées en série.

Chaque étage de détection présente donc un transistor bipolaire T1, T2 dont les bases 11, 12 sont reliées respectivement aux points de connexion C1, C2 à travers des résistances électriques R2, R3 et R4, R5.

Les résistances R1, R2, R3, R4, R5, R6 et R7 sont choisies de manière à ne produire qu'un faible courant électrique de fuite, d'une intensité maximale inférieure à 0,7 milli-Ampères et préférentiellement inférieure à 0,2 milli-Ampères pour ne pas mettre en danger l'utilisateur qui manipule le fer à repasser 1, par exemple.

A ce titre, les valeurs préférentielles ohmiques des résistances R1, R2, R3, R4, R5, R6 et R7 sont respectivement sensiblement égales à 47 000 Ohms pour R1, 1 000 Ohms pour R2, R3, R4 et R5, 68 000 Ohms pour R6 et 470 000 Ohms pour R7.

Par ailleurs, les valeurs ohmiques sont choisies avantageusement pour détecter à l'aide des transistors bipolaires T1 et T2, un très faible courant dont l'intensité est supérieure à 7 micro-Ampères.

Il est évident que le choix de valeurs ohmiques différentes dans le circuit électronique 10 n'altère nullement le fonctionnement du dispositif et ne sort pas, par conséquent, du cadre de la présente invention.

Le circuit électronique (10) est constitué de deux étages de détection reliés à un moyen de liaison électrique 2, par l'intermédiaire des points de connexion C1, C2, pour détecter dans au moins un des étages de détection, un courant de fuite circulant entre la terre et l'un des moyens de liaison électrique 2, en traversant le corps de l'utilisateur.

Selon une variante de réalisation du circuit électronique 10 conforme à l'invention, il est envisagé d'utiliser des transistors à effet de champ en apportant quelques modifications à la structure du circuit électronique 10.

Selon un mode de fonctionnement et de réalisation préférentiel du dispositif de détection conforme à l'invention, la borne P et la borne N correspondent respectivement à la phase et au neutre de l'alimentation électrique du secteur. L'inversion de la phase et du neutre de l'alimentation électrique n'altère aucunement le bon fonctionnement du dispositif de détection.

Le circuit électronique 10 de détection permet de détecter un courant électrique de fuite circulant entre les moyens de liaison électrique 2, avantageusement à travers une main par exemple du manipulateur du fer à repasser 1.

Le circuit électronique 10 permet également de détecter un courant électrique de fuite circulant de l'un des moyens de liaison électrique 2 vers la terre à travers la main de l'utilisateur du fer à repasser, laquelle vient en contact avec lesdits moyens de liaison électrique 2.

Le fonctionnement du dispositif est donc assuré indépendamment de l'isolation électrique pouvant exister entre l'utilisateur et la terre.

Lorsque l'utilisateur ne porte pas sa main sur la poignée 4 du fer à repasser 1 aucun courant électrique ne permet de produire un signal électrique sur le collecteur S du transistor bipolaire T2.

Lorsque l'utilisateur ou le manipulateur du fer à repasser 1 porte sa main sur la poignée 4 et par conséquent sur les moyens de liaison électrique 2, deux situations peuvent se présenter.

Dans la première situation, l'utilisateur se trouve fortement isolé électriquement par rapport à la terre. Ainsi, un faible courant électrique de fuite circule du point de connexion C1 vers le point de connexion C2, à travers les moyens de liaison électrique 2 et la main de l'utilisateur. Chaque alternance positive du secteur provoque un signal électrique sur la base 12 du transistor T2 qui détecte de cette façon la présence de la main de l'utilisateur sur la poignée 4, même si l'utilisateur ne se trouve pas à la masse.

Dans la deuxième situation, l'utilisateur n'est pas, ou faiblement, isolé électriquement par rapport à la terre. Un faible courant électrique de fuite circule ainsi de l'un des points de connexion C1 ou C2 vers la terre.

Dans ce cas de figure, le contact avec un seul moyen de liaison électrique 2 peut suffire pour obtenir un signal sur le collecteur S lorsque l'un des étages de détection, relié à la phase du secteur est mis à la terre par l'intermédiaire d'un point de connexion C1, C2.

La borne P d'alimentation est par exemple branchée sur la phase du secteur, ce qui a pour conséquence, pour chaque alternance positive, de produire un courant électrique de l'émetteur vers le collecteur du transistor T1, grâce à la tension électrique présente aux bornes de la résistance R1 qui provoque la saturation du transistor T1. La base 12 du transistor T2 est alimentée de cette manière, et un signal est obtenu sur le collecteur S dudit transistor T2.

Si la borne P d'alimentation est par exemple branchée sur le neutre du secteur, lequel est relié à la terre, c'est également l'alternance positive du secteur qui produit un signal sur le collecteur S du transistor T2 directement. Le dispositif conforme à l'invention détecte donc la présence d'une partie du corps d'un utilisateur par les alternances positives du secteur.

C'est ainsi le deuxième étage de détection, comprenant le transistor bipolaire T2 qui est actif. En effet, lorsque la borne N se trouve branchée sur la phase du secteur, un courant circulant à travers les résistances R6, R5 et R4 vers la terre par l'intermédiaire du point de connexion C2 provoque un signal électrique sur la base 12. Lorsque l'utilisateur n'est pas isolé par rapport à la terre, le contact dudit utilisateur avec l'unique point de connexion C2 est suffisant pour obtenir un signal sur le collecteur S.

Aucun signal électrique n'est produit sur le collecteur S aussitôt que l'utilisateur n'est plus en contact avec les moyens de liaison électrique.

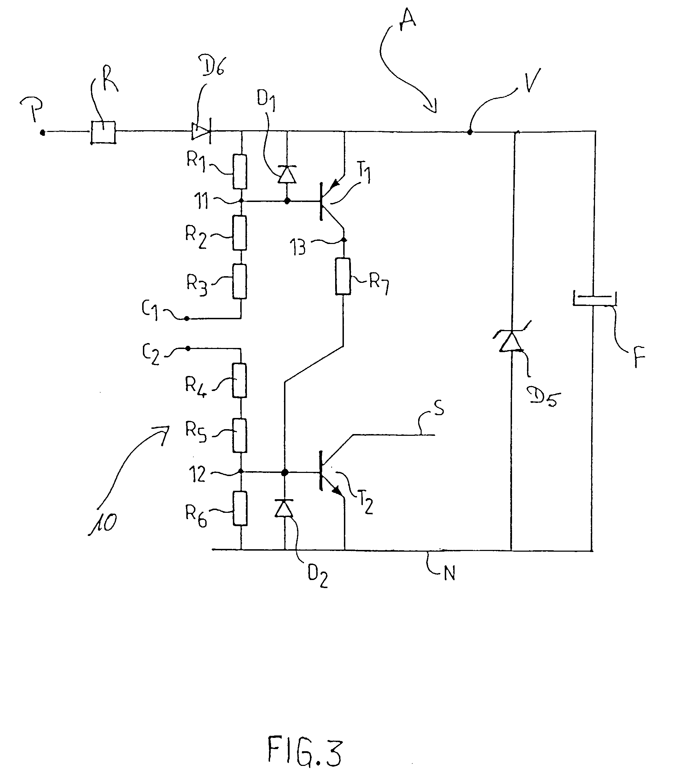

Selon une variante de réalisation du circuit électronique 10, représenté à la figure 3, ledit circuit électronique 10 est associé à une alimentation électrique A fournissant une tension électrique continue aux étages de détection. L'alimentation électrique A est constituée d'une résistance R en série avec une diode D6, lesquelles sont branchées entre la borne P et une borne V, ainsi que d'un condensateur F, en parallèle avec une diode Zéner D5, branchés entre la borne V et la borne N.

Selon un exemple de branchement, la borne P est sur la phase du secteur.

La résistance R permet de faire chuter la tension à la borne V. La diode D6 et le condensateur F réalisent ainsi une alimentation filtrée continue. En outre la diode Zéner D5 permet de maintenir la tension de l'alimentation A à un potentiel par exemple inférieur à 24 volt à la borne V et de choisir en conséquence les caractéristiques des transistors bipolaires T1, T2, utilisés dans les étages de détection.

Le circuit électronique 10 est ainsi sensible à différents cas de figure qui peuvent se présenter lors de l'utilisation de l'appareil électrique muni d'un dispositif conforme à l'invention.

Lorsque l'utilisateur se trouve à la terre ou à la masse, le fonctionnement du circuit électronique 10 est identique au fonctionnement du premier mode de réalisation dudit circuit représenté à la figure 2.

Lorsque l'utilisateur est isolé par rapport à la terre, le courant de fuite entre les points de connexion C1 et C2 est obtenu par l'alimentation électrique A, fournissant une tension sensiblement continue à la borne V.

La présence d'un signal sur le collecteur S permet ainsi de commander, en temps réel, diverses fonctions réalisables par un appareil électrique tel qu'un fer à repasser par exemple. De telles fonctions correspondent notamment à la génération de vapeur d'eau, à l'alimentation électrique d'éléments chauffants.

Un dispositif conforme à l'invention permet donc d'asservir automatiquement un appareil électrique comportant des moyens de production de vapeur, par l'intermédiaire d'un courant de fuite.

Il est envisageable de commander le fonctionnement de témoins lumineux, ou d'autres organes présents dans des appareils électriques pour le soin de la personne, du type masseurs électriques, sèche-cheveux électriques, épileurs et rasoirs notamment.

Un avantage du dispositif de détection de présence conforme à l'invention réside dans l'utilisation générale dudit dispositif. Il est utilisable sur des appareils électriques de tous genres et même sur ses appareils comportant un transformateur d'isolement. Dans ce cas précis, la détection est simplifiée, vu qu'il n'y a qu'un courant de fuite entre deux électrodes à détecter. L'un des étages de détection peut alors être inopérant.

Un autre avantage du dispositif conforme à l'invention est lié à l'utilisation d'un circuit électronique 10, opérationnel indépendamment du sens du branchement sur le secteur ou de l'isolation que peut présenter l'utilisateur par rapport à la terre.

Un autre avantage du dispositif conforme à l'invention, réside dans la fiabilité d'un tel système de détection. En effet, l'utilisateur peut être plus ou moins isolé par rapport à la terre, présenter une isolation par rapport à la terre variable dans le temps ou être en contact avec l'une seulement des électrodes constitutives des moyens de liaison électrique 2. Toutes les possibilités d'utilisation, ou une combinaison de ces possibilités est détectée par le dispositif conforme à l'invention, conférant ainsi audit dispositif une grande efficacité. En outre, la sensibilité du dispositif de détection peut varier en fonction du choix des résistances R1 et R6. Avantageusement, les résistances R1 et R6 sont ajustables par l'utilisateur pour tenir compte des différences que peuvent présenter les valeurs ohmiques de la résistance électrique de la peau des utilisateurs, lesquels viennent en contact avec le dispositif de détection.

Un avantage supplémentaire du dispositif conforme à l'invention réside dans la sécurité accrue que procure un tel dispositif agencé sur un appareil électrique. En effet, on peut envisager une coupure de l'alimentation électrique ou de l'alimentation en vapeur pour un fer à repasser, dès que l'utilisateur ou le manipulateur ne touche plus, avec sa main par exemple, les moyens de liaison électriques 2.

Le confort d'utilisation d'un tel appareil électroménager se trouve ainsi amélioré.

Un avantage additionnel du dispositif de détection conforme à l'invention réside dans l'utilisation d'un circuit électronique 10, lequel peut d'une part être combiné à tout autre moyen de contrôle, de régulation, ou d'asservissement du fonctionnement d'un appareil électrique, et d'autre part être agencé sur l'appareil même ou dans une unité externe associée et reliée électriquement au dit appareil. Une carte électronique peut également être placée dans la poignée 4 pour gérer des informations issues de capteurs de grandeurs physiques.

Un avantage du circuit électronique 10 conforme à l'invention réside dans sa conception simple, peu coûteuse et adaptée à l'utilisation de moyens structurels, du type moyens de liaison électrique 2, peu encombrants, facilement adaptables à tous types d'appareils électriques, et très peu coûteux.

### POSSIBILITES D 'APPLICATION INDUSTRIELLE

L'invention trouve son application industrielle dans le domaine des appareils électriques destinés à être pris en main par l'utilisateur dudit appareil, et notamment des fers à repasser à vapeur.

## Revendications

1. Dispositif de détection associé à un appareil électrique et à un circuit électronique (10), pour détecter un courant de fuite traversant au moins partiellement, une partie du corps d'un utilisateur de l'appareil électrique lorsque ladite partie du corps vient en contact avec des moyens de liaison électrique (2) agencés sur un moyen de préhension de l'appareil, assurant ainsi la transmission du courant de fuite du circuit électronique (10) vers le corps de l'utilisateur, et permettant de commander au moins une partie du fonctionnement de l'appareil électrique par respectivement un contact ou une séparation entre le moyen de préhension et l'utilisateur,
caractérisé en ce que chaque moyen de liaison électrique (2) est relié à un étage de détection de courant de fuite, de façon à permettre une détection lorsque le courant de fuite circule entre les moyens de liaison électrique (2), et lorsque ledit courant circule entre l'un des moyens de liaison électrique (2) et la terre.

2. Dispositif selon la revendication 1 caractérisé en ce que les moyens de liaison électrique (2) sont constitués de deux barrettes métalliques reliées au circuit électronique (10) par des points de connexion (C1, C2) et isolées électriquement l'une de l'autre par un espacement, de façon à permettre à la partie du corps de l'utilisateur qui vient en contact avec lesdits moyens de liaison électrique (2) de réaliser un pont électrique soit entre les barrettes métalliques, soit entre l'une des barrettes métalliques et la terre.

3. Dispositif selon l'une des revendications 1 ou 2 caractérisé en ce que le circuit électronique (10) est constitué de deux étages de détection reliés à un moyen de liaison électrique (2) par l'intermédiaire de points de connexion (C1, C2) pour détecter dans au moins un des étages de détection, un courant de fuite circulant entre la terre et l'un des moyens de liaison électrique (2) en traversant le corps de l'utilisateur.

4. Dispositif selon la revendication 3 caractérisé en ce que l'un des étages de détection est relié à la phase et l'autre est relié au neutre de l'alimentation électrique du secteur.

5. Dispositif selon l'une des revendications 3 ou 4 caractérisé en ce que chaque étage de détection présente un transistor bipolaire (T1, T2) dont les bases (11, 12) sont reliées respectivement aux points de connexion (C1, C2) à travers des résistances électriques (R2-R3, R4-R5).

6. Dispositif selon la revendication 5 caractérisé en ce que les transistors bipolaires (T1, T2) présentent des émetteurs connectés sur une alimentation électrique, le collecteur du premier transistor (T1) étant relié à la base (12) du deuxième transistor (T2) à travers une résistance (R7), et le collecteur (S) du deuxième transistor (T2) étant relié à un moyen de commande et/ou de contrôle d'un appareil électrique.

7. Dispositif selon la revendication 6 caractérisé en ce que la base (11) du transistor (T1) est reliée à une borne (P) d'alimentation à travers une résistance (R1) laquelle est branchée en parallèle avec une diode (D1) d'une part et que la base (12) est reliée à une borne (N) d'alimentation à travers une résistance (R6) branchée en parallèle avec une diode (D2).

8. Dispositif selon l'une des revendications 3 à 7 caractérisé en ce que le circuit électronique (10) est associé à une alimentation électrique A, fournissant une tension électrique continue aux étages de détection.

9. Dispositif selon l'une des revendications précédentes caractérisé en ce qu'il est monté sur un appareil électrique comportant des moyens de chauffe dont l'alimentation électrique est contrôlée par le circuit électronique (10) en fonction de l'apparition ou de la disparition du courant de fuite.

10. Dispositif selon l'une des revendications précédentes caractérisé en ce qu'il est monté sur un appareil électrique comportant des moyens de production de vapeur, laquelle est asservie automatiquement par l'intermédiaire du courant de fuite.

11. Dispositif selon l'une des revendications précédentes caractérisé en ce que le circuit électronique (10) est agencé dans une unité externe et séparée de l'appareil électrique en liaison électrique avec ledit appareil électrique.

12. Appareil électroménager caractérisé en ce qu'il comporte un dispositif de détection conforme à l'une des revendications 1 à 11.

13. Fer à repasser à vapeur caractérisé en ce qu'il comporte un dispositif de détection conforme à l'une des revendications 1 à 11.

14. Appareil électrique pour le soin de la personne caractérisé en ce qu'il comporte un dispositif de détection conforme à l'une des revendications 1 à 11.

## Patentansprüche

1. Erfassungsvorrichtung, die einem elektrischen Gerät und einer elektronischen Schaltung (10) zugeordnet ist, um einen Kriechstrom zu erfassen, der wenigstens teilweise einen Teil des Körpers eines Benutzers des elektrischen Gerätes durchquert, wenn der Teil des Körpers mit an einem Griff des Gerätes angeordneten elektrischen Verbindungsmitteln (2) in Berührung gelangt, welche die Übertragung des Kriechstroms (10) zum Körper des Benutzers gewährleisten und ermöglichen, wenigstens einen Teil des Betriebs des elektrischen Gerätes durch einen Kontakt bzw. eine Trennung zwischen dem Griff und dem Benutzer zu steuern,
dadurch gekennzeichnet, daß jedes elektrische Verbindungsmittel (2) mit einer Kriechstrom-Erfassungsstufe verbunden ist, so daß eine Erfassung möglich ist, wenn der Kriechstrom zwischen den elektrischen Verbindungsmitteln (2) zirkuliert und wenn der Strom zwischen einem der elektrischen Verbindungsmittel (2) und der Erde zirkuliert.

2. Vorrichtung nach Anspruch 1, dadurch gekennzeichnet, daß die elektrischen Verbindungsmittel (2) durch zwei Metallstege gebildet sind, die mit der elektronischen Schaltung (10) über Anschlußstellen (C1, C2) verbunden und elektrisch voneinander durch einen Abstand isoliert sind, so daß der Körperteil des Benutzers, der mit den elektrischen Verbindungsmitteln (2) in Berührung kommt, eine elektrische Brücke entweder zwischen den Metallstegen oder zwischen einem der Metallstege und der Erde bilden kann.

3. Vorrichtung nach einem der Ansprüche 1 und 2, dadurch gekennzeichnet, daß die elektronische Schaltung (10) durch zwei Erfassungsstufen gebildet ist, die mit einem elektrischen Verbindungsmittel (2) über Anschlußstellen (C1, C2) verbunden sind, um in wenigstens einer der Erfassungsstufen einen Kriechstrom zu erfassen, der zwischen der Erde und einem der elektrischen Verbindungsmittel (2) durch den Körper des Benutzers hindurch zirkuliert.

4. Vorrichtung nach Anspruch 3, dadurch gekennzeichnet, daß eine der Erfassungsstufen mit der Phase und die andere mit dem Nulleiter der elektrischen Netzversorgung verbunden ist.

5. Vorrichtung nach einem der Ansprüche 3 oder 4, dadurch gekennzeichnet, daß jede Erfassungsstufe einen bipolaren Transistor (T1, T2) aufweist, deren Basen (11, 12) mit den Anschlußstellen (C1 C2) über elektrische Widerstände (R2-R3, R4-R5) verbunden sind.

6. Vorrichtung nach Anspruch 5, dadurch gekennzeichnet, daß die bipolaren Transistoren (T1, T2) Emitter aufweisen, die mit einer elektrischen Versorgung verbunden sind, wobei der Kollektor des ersten Transistors (T1) mit der Basis (12) des zweiten Transistors (T2) über einen Widerstand (R7) verbunden ist und der Kollektor (S) des zweiten Transistors (T2) mit einem Mittel zum Steuern und/oder Kontrollieren eines elektrischen Geräts verbunden ist.

7. Vorrichtung nach Anspruch 6, dadurch gekennzeichnet, daß die Basis (11) des Transistors (T1) mit einer Versorgungsklemme (P) über einen Widerstand (R1) verbunden ist, der mit einer Diode (T1) parallel geschaltet ist, und daß die Basis (12) mit einer Versorgungsklemme (N) über einen Widerstand (R6) verbunden ist, der mit einer Diode (T2) parallel geschaltet ist.

8. Vorrichtung nach einem der Ansprüche 3 bis 7, dadurch gekennzeichnet, daß der elektronischen Schaltung (10) eine elektrische Versorgung A zugeordnet ist, die den Erfassungsstufen eine elektrische Gleichspannung liefert.

9. Vorrichtung nach einem der vorhergehenden Ansprüche, dadurch gekennzeichnet, daß sie an einem elektrischen Gerät angebracht ist, das Heizmittel aufweist, deren elektrische Versorgung von der elektronischen Schaltung (10) in Abhängigkeit vom Auftreten oder Verschwinden des Kriechstroms kontrolliert wird.

10. Vorrichtung nach einem der vorhergehenden Ansprüche, dadurch gekennzeichnet, daß sie an einem elektrischen Gerät angebracht ist, das ein Dampferzeugungsmittel aufweist, das automatisch durch das Auftreten des Kriechstroms geregelt wird.

11. Vorrichtung nach einem der vorhergehenden Ansprüche, dadurch gekennzeichnet, daß die elektronische Schaltung (10) in einer externen und von dem elektrischen Gerät getrennten Einheit in elektrischer Verbindung mit diesem angeordnet ist.

12. Elektrogerät, dadurch gekennzeichnet, daß es eine Erfassungsvorrichtung nach einem der Patentansprüche 1 bis 11 aufweist.

13. Dampfbügeleisen, dadurch gekennzeichnet, daß es eine Erfassungsvorrichtung nach einem der Patentansprüche 1 bis 11 aufweist.

14. Elektrisches Gerät für die Körperpflege, dadurch gekennzeichnet, daß es eine Erfassungsvorrichtung nach einem der Patentansprüche 1 bis 11 aufweist.

## Claims

1. Detection apparatus associated with an electrical appliance and with an electronic circuit (10) for detecting a leakage current flowing at least in part through a part of the body of a user of the electrical appliance when said part of the body comes into contact with electrical coupling means (2) disposed on graspable means that are grasped when taking hold of the appliance, thereby enabling the leakage current to be transmitted from the electronic circuit (10) to the body of the user, and enabling at least a portion of the operation of the electrical appliance to be controlled respectively by contact being set up between the graspable means and the user and by contact being broken therebetween, said apparatus being
characterized in that each electrical coupling means (2) is connected to a leakage current detection stage so as to enable detection to take place when a leakage current flows between the electrical coupling means (2), and when said current flows between one of the electrical coupling means (2) and ground.

2. Apparatus according to claim 1, characterized in that the electrical coupling means (2) are constituted by two metal strips connected to the electronic circuit (10) via connection points (C1, C2) and insulated electrically from each other by a gap, so as to enable the part of the body of the user that comes into contact with said electrical coupling means (2) to form an electrical bridge either between the metal strips or between one of the metal strips and ground.

3. Apparatus according to claim 1 or 2, characterized in that the electronic circuit (10) is constituted by two detection stages connected to electrical coupling means (2) via connection points (C1, C2) for detecting in at least one of the detection stages a leakage current flowing between ground and one of the electrical coupling means (2) through the body of the user.

4. Apparatus according to claim 3, characterized in that one of the detection stages is connected to the live of the mains electrical power supply and the other detection stage is connected to the neutral of the mains electrical power supply.

5. Apparatus according to claim 3 or 4, characterized in that each detection stage includes a bipolar transistor (T1, T2) whose base (11, 12) is connected to a respective one of the connection points (C1, C2) via respective electrical resistors (R2 & R3, R4 & R5).

6. Apparatus according to claim 5, characterized in that the bipolar transistors (T1, T2) have emitters connected to an electrical power supply, the collector of the first transistor (T1) being connected to the base (12) of the second transistor (T2) via a resistor (R7), and the collector (S) of the second transistor (T2) being connected to means for controlling and/or monitoring an electrical appliance.

7. Apparatus according to claim 6, characterized in that the base (11) of the transistor (T1) is connected to one power supply terminal (P) via a resistor (R1) which is connected in parallel with a diode (D1), and in that the base (12) of the transistor (T2) is connected to the other power supply terminal (N) via a resistor (R6) connected in parallel with a diode (D2).

8. Apparatus according to any one of claims 3 to 7, characterized in that the electronic circuit (10) is associated with an electrical power supply A, supplying a DC voltage to the detection stages.

9. Apparatus according to any preceding claim, characterized in that it is mounted on an electrical appliance including heater means for which the electrical power supply is controlled by the electronic circuit (10) as a function of the appearance or of the disappearance of the leakage current.

10. Apparatus according to any preceding claim, characterized in that it is mounted on an electrical appliance including steam-generating means, steam generation being servo-controlled automatically by means of the leakage current.

11. Apparatus according to any preceding claim, characterized in that the electronic circuit (10) is disposed in an external unit that is separate from the electrical appliance and that is electrically coupled to said electrical appliance.

12. A household electrical appliance, characterized in that it includes detection apparatus according to any one of claims 1 to 11.

13. A steam iron characterized in that it includes detection apparatus according to any one of claims 1 to 11.

14. An electrical appliance for personal care, characterized in that it includes apparatus according to any one of claims 1 to 11.
